# EUROPEAN PATENT APPLICATION

(11) **EP 2 477 207 A2**
(43) Date of publication of application: **18.07.2012**
(21) Application number: 12154112.2
(22) Date of filing: 23.09.2005
(51) Int. Cl.: H01J 37/32, H01J 37/34

(54) **Apparatus for generating high-current electrical discharges**

(30) Priority: 24.09.2004 US 612852 P
(62) Divisional of application: 05800880.6
(71) Applicant: Zond, Inc., Mansfield, MA 02048 (US)
(72) Inventor: Chistyakov, Roman, Andover MA 01810 (US)
(74) Representative: Jackson, Robert Patrick

(57) **Abstract**

A high current density plasma generator includes a chamber (104) that contains a feed gas. An anode (124) is positioned in the chamber. A cathode assembly (116) is position adjacent to the anode inside the chamber. A power supply (102) having an output is electrically connected between the anode and the cathode assembly. The power supply generates at the output an oscillating voltage that produces a plasma from the feed gas. At least one of an amplitude, frequency, rise time, and fall time of the oscillatory voltage is chosen to increase an ionization rate of the feed gas (108).

## Description

### Related Application Section

This application claims priority to U.S. Provisional Patent Application Serial Number 60/612,852, filed September 24, 2004, entitled "Apparatus for Generating High Current Electrical Discharges." U.S. Provisional Patent Application Serial Number 60/61 2,852 is incorporated herein by reference.

### Introduction

A plasma can be created in a chamber by igniting a direct current (DC) electrical discharge between two electrodes in the presence of a feed gas. The electrical discharge generates electrons in the feed gas that ionize atoms thereby creating an electrically neutral plasma. The electrons in the plasma provide a path for an electric current to pass through the plasma.

Plasma density in known plasma systems is typically increased by increasing the electrode voltage. The increased electrode voltage increases the discharge current and thus the plasma density. However, the electrode voltage is limited in many applications because high electrode voltages can cause undesirable heating which can have a negative affect on the properties of films being deposited or etched. In addition, high electrode voltages can cause arcing that can damage the equipment and/or the work piece being exposed to the electrical discharge.

### Brief Description of the Drawings

The aspects of this invention may be better understood by referring to the following description in conjunction with the accompanying drawings, in which like numerals indicate like structural elements and features in various figures. The drawings are not necessarily to scale. The skilled artisan will understand that the drawings, described below, are for illustration purposes only. The drawings are not intended to limit the scope of the present teachings in any way.

FIG. 1 illustrates a cross-sectional view of a plasma sputtering apparatus having a power supply according to one embodiment of the invention.

FIG. 2 illustrates data for discharge voltage and discharge current waveforms as a function of time for a known DC plasma generator.

FIG. 3 illustrates data for discharge voltage and discharge current waveforms as a function of time for a plasma generator powered by relatively slow discharge voltage oscillations according to the present invention.

FIG. 4 illustrates data for discharge current and discharge voltage waveforms as a function of time for a plasma generator powered by relatively fast discharge voltage oscillations according to the present invention.

FIG. 5 illustrates data for discharge current and discharge voltage waveforms as a function of time for a plasma generator powered by relatively fast discharge voltage oscillations having a rising voltage according to the present invention.

FIG. 6 illustrates data for discharge current and discharge voltage waveforms as a function of time for a plasma generator powered by a pulsed oscillatory voltage waveform.

FIG. 7 illustrates data for discharge current and discharge voltage waveforms as a function of time for a plasma generator powered by an oscillatory voltage waveform having two different frequencies.

### Detailed Description

The section headings used herein are for organizational purposes only and should not to be construed as limiting the subject matter described in the present application.

While the present teachings are described in conjunction with various embodiments and examples, it is not intended that the present teachings be limited to such embodiments. On the contrary, the present teachings encompass various alternatives, modifications and equivalents, as will be appreciated by those of skill in the art.

It should be understood that the individual steps of the methods of the present invention may be performed in any order and/or simultaneously as long as the invention remains operable. Furthermore, it should be understood that the apparatus of the present invention can include any number or all of the described embodiments as long as the invention remains operable.

Electrical direct current (DC) gas discharges are used for numerous applications, such plasma processing applications for the semiconductor and other industries. Electrical discharges are often produced with a mixture of molecular and/or atomic feed gases. Many plasma etching and plasma deposition applications in semiconductor and others industries use direct high current electrical discharges.

The present invention relates to methods and apparatus for creating high-current electrical discharges. The term "high current electrical discharge" is defined herein to mean electrical discharges having current densities that are greater than about 0.25 A/cm2. According to Ohm law, the electrical current in DC discharges is proportional to the applied electrical field E and the electrical conductivity of the gas discharge. The electrical conductivity is proportional to the electron density, and depends on electron energy and the collision frequencies with other particles, such as neutral atoms and/or neutral molecules, in the discharge volume. The conductivity of a completely ionized plasma is determined by Spitzer formula, which indicates that the conductivity is independent of the electron density.

The desired discharge current in known commercial available DC power supplies for plasma processing tools is regulated by adjusting the voltage level applied to the plasma. Gas ionization is increased by increasing the voltage applied to the plasma. Adjusting the voltage applied to the plasma generally occurs on a time scale that is relatively slow compare with the collision frequency of electrons and others particles in the gas discharge and slow compared with the time necessary to establish plasma equilibrium. Known methods of generating and sustaining high direct current electrical discharges require the application of high voltages. For example, voltages in the range of about 1,000 -3,000V are typically required to generate and sustain high-current electrical discharges.

The present invention is described in connection with a magnetron sputtering apparatus. However, it is understood that the methods and apparatus of the present invention apply to any type of plasma generator. Magnetron sputtering apparatus are widely used in the materials processing industry because they are very versatile. Magnetron sputtering apparatus can be used to sputter numerous types of materials with a wide range of deposition rates.

The quality of the sputtered film depends upon the density of sputtered material ions in the plasma. Applying a negative electrical bias to the substrate will attract ions and provide the necessary energy to form a high quality film. In addition, the deposition rate of material sputtered with a magnetron sputtering apparatus depends upon the density of sputtered gas ions. The sputtered material ions density and gas ions density can be increased by increasing the electrical power applied to the magnetron. The deposition rate of sputtered material and quality of the film can be increased by increasing the electrical power applied to the magnetron. The density of the plasma generated by the magnetron discharge can also be increased by increasing the electrical power applied to the magnetron.

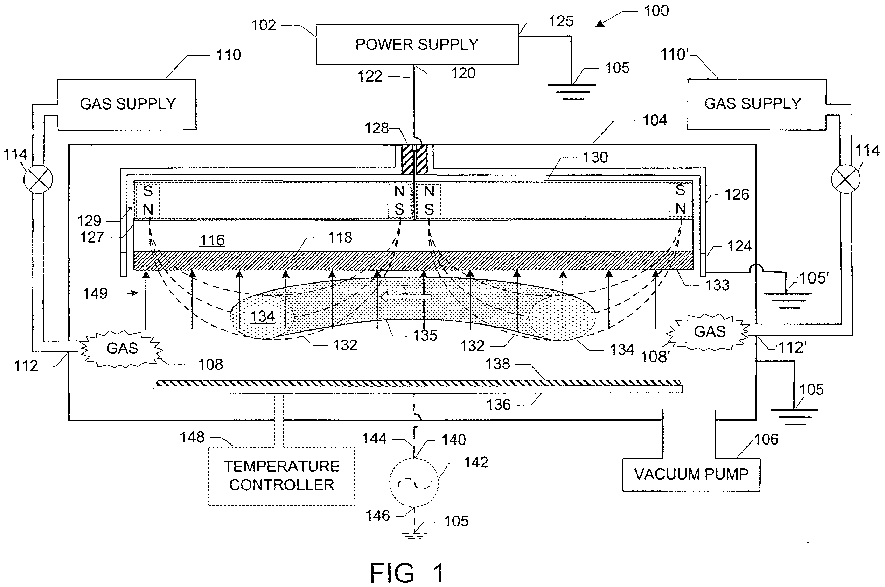

FIG. 1 illustrates a cross-sectional view of a plasma sputtering apparatus 100 having a power supply 102 according to one embodiment of the invention. Although FIG. 1 illustrates a cross-sectional view of a plasma sputtering apparatus 100, it will be clear to skilled artisans that the principles of the present invention can be used in many other types of plasma systems, such as plasma sputter-etch systems, plasma reactive ion etch (RIE) systems, hollow cathode magnetrons, ion beam generators, plasma-enhanced chemical vapor deposition (CVD) systems, plasma accelerators, plasma rocket thrusters, plasma traps, and other plasma system that uses crossed electric and magnetic fields or plasma systems that uses only electric fields, such as gas lasers, gas switches, and lightning devices.

The plasma sputtering apparatus 100 includes a power supply 102 that generates an oscillatory voltage waveform. In some embodiments, the power supply 102 comprises two separate power supplies, one that generates a DC voltage and another that generates an AC voltage. The oscillatory waveform can be a complex oscillatory voltage waveform that includes at least two sinusoidal waveforms. In some embodiments, the power supply 102 can include circuitry that minimizes or eliminates the probability of arcing. A vacuum chamber 104 contains a plasma. The vacuum chamber 104 can be coupled to ground 105. The vacuum chamber 104 is positioned in fluid communication with a vacuum pump 106 that is used to evacuate the vacuum chamber 104 to a high vacuum that is in the range of 10⁻⁵ to 10⁻¹¹Torr. The pressure inside the vacuum chamber 104 is generally less than 0.1Torr during most plasma operating conditions. In some embodiment the gas pressure greater than 0.1Torr.

A process or feed gas 108 is introduced into the vacuum chamber 104 through a gas inlet 112 from a feed gas source 110, such as an Argon gas source. The flow of the feed gas is controlled by a valve 114. In some embodiments, a second process or feed gas 108" is introduced into the vacuum chamber 104 through a second gas inlet 112' from a second feed gas source 110'. In these embodiments, the second feed gas source 110' can' be a reactive gas, such as an Oxygen and/or Nitrogen source for reactive materials processing, such as reactive sputtering, reactive etching, and plasma enhanced chemical vapor deposition. In some embodiments, at least one of the gas sources 110, 110' is an excited atom or metastable atom source as described in U.S. Patent Number 6,805,779 B2, entitled "Plasma Generation Using Multi-Step Ionization" which is assigned to the current assignee.

The plasma sputtering apparatus 100 also includes a cathode assembly 116. The cathode assembly 116 shown in FIG. 1 is formed in the shape of a circular disk, but can be formed in other shapes. In some embodiments, the cathode assembly 116 includes a target 118 for sputtering. The cathode assembly 116 is electrically connected to a first terminal 120 of the power supply 102 with an electrical transmission line 122.

A ring-shaped anode 124 is positioned in the vacuum chamber 104 proximate to the cathode assembly 116. The anode 124 is electrically connected to ground 105. A second terminal 125 of the power supply 102 is also electrically connected to ground 105. In other embodiments, the anode 124 is electrically connected to the second terminal 125 of the power supply 102, which is not at ground potential.

A housing 126 surrounds the cathode assembly 116. The anode 124 can be integrated with or electrically connected to the housing 126. The outer edge 127 of the cathode assembly 116 is electrically isolated from the housing 126 with insulators 128. The gap 1 29 between the outer edge 127 of the cathode assembly 116 and the housing 126 can be a vacuum gap or can include a dielectric material. In some embodiments, cooling mechanisms can be used to cool at least one of the cathode assembly 116 and the anode 124.

In some embodiments, the plasma sputtering apparatus 100 includes a magnet assembly 130 that generates a magnetic field 132 proximate to the target 118. The magnetic field 132 is less parallel to the surface of the cathode assembly 116 at the poles of the magnets in the magnet assembly 130 and more parallel to the surface of the cathode assembly 116 in the region 134 between the poles of the magnets in the magnetic assembly 130. The magnitude of the magnetic field component that is parallel to the target surface can be in the range 20-2000 Gauss. The magnetic field 132 is shaped to trap and concentrate secondary electrons emitted from the target 118 that are proximate to the target surface 133. The magnet assembly can consist of rotating magnets.

In one embodiment, the plasma sputtering apparatus 100 includes a segmented magnetron as described in co-pending patent application serial number 10/710,946, entitled "Plasma Source with Segmented Magnetron Cathode," which is incorporated herein by reference. Patent application serial number 10/710,946 is assigned to the present assignee. In this embodiment, the segmented magnetron cathode includes a plurality of magnetron cathode segments that are positioned in the chamber proximate to the anode. Each of the plurality of magnetron cathode segments are electrically isolated from each of the other magnetron cathode segments. A switch is used to connect the output of a power supply to each of the plurality of magnetron cathode segments.

The magnetic field 132 increases the density of electrons and therefore, increases the plasma density in the region 134 that is proximate to the target surface 133. The magnetic field 132 can also induce an electron Hall current 135 that is formed by the crossed electric and magnetic fields. The strength of the electron Hall current 135 depends, at least in part, on the density of the plasma and the strength of the crossed electric and magnetic fields.

The plasma sputtering apparatus 100 also includes a substrate support 136 that holds a substrate 138 or other work piece for plasma processing. In some embodiments, the substrate support 136 is biased with a radio frequency (RF) field. In some embodiments, the frequency of the RF field is in the range of about 1 MHz-1 00 MHz. In one embodiment, the RF frequency is 13.56 MHz and a generated negative bias is in the range of about 1 to 1,000V. In some embodiments, the substrate support 136 is biased with alternative current (AC) field. In some of these embodiments, the AC frequency is in the range of about 1 KHz-1 MHz. In other embodiments, the substrate support 136 is biased with DC power supply. The DC bias voltage can in the range of about +1,000V to -100KV. In these embodiments, the substrate support 136 is electrically connected to an output 140 of a power supply 142 with an electrical transmission line 144. A matching network (not shown) may be used to couple the RF or AC power supply 142 to the substrate support 136. In some embodiments, a temperature controller 148 is thermally coupled to the substrate support 136. The temperature controller 148 regulates the temperature of the substrate 1 38 during processing. For example, for some processes, the substrate temperature is between -1 00C and + 1.000C.

In operation, the vacuum pump 106 evacuates the chamber 104 to the desired operating pressure. The feed gas source 110 injects feed gas 108 into the chamber 104 through the gas inlet 112. Many material processing systems for sputtering use only a noble feed gas, such as Argon, to generate plasma. In one embodiment, the plasma sputtering apparatus 100 is configured for the reactive sputtering of material such as Al₂O₃. In this embodiment, the second feed gas source 110' injects a second feed gas, such as Oxygen 108' into the chamber 104' through the gas inlet 112' in addition to the Argon feed gas. In one embodiment, the magnetron sputtering apparatus 100 is configured for reactive sputtering in a pure reactive gas environment, such as reactive sputtering of Al₂O₃ with only an Oxygen environment.

In some embodiments, the magnetron sputtering apparatus 100 uses a combination of at least one noble feed gases and at least one reactive feed gas to generate a plasma for reactive plasma processing. In other embodiments, the magnetron sputtering apparatus 100 uses at least one reactive feed gas to generate a plasma for reactive plasma processing and does not use any noble gases.

The power supply 102 applies a negative oscillatory voltage to the cathode assembly 116 that cause an oscillating electric field 149 to develop between the target 118 and the anode 124. In one embodiment, the power supply 102 applies an oscillatory voltage with both a negative and positive portion. In this embodiment, the oscillating voltage will reduce charging effect on the cathode assembly and target during the reactive sputtering process. The oscillating voltage will also affect the Hall current because Hall currents in closed loop devises, such as magnetrons, are proportional to the electric field.

The power supply 102 can operate in the power mode, the voltage mode, or the current mode. In the power mode, the output voltage of the power supply 102 is adjusted to achieve the desired plasma discharge power. In the voltage mode, the output voltage of the power supply 102 is adjusting to achieve the desired plasma discharge voltage. In the current mode, the output voltage of the power supply is adjusting to achieve the desired plasma discharge current (current mode). The characteristics of the voltage generated by the power supply 102 and the resulting plasmas are discussed in connection with the following figures.

In one embodiment, the oscillatory voltage waveform is chosen so as to prevent arcing. Arcing is generally undesirable because it can damage the anode 124 and cathode assembly 116 and can generate particles that can contaminate or damaged layer on the wafer or work piece being processed. In one embodiment, the circuitry of the power supply 102 limits the plasma discharge current to a predetermined limit, and if this limit is exceeded, energy provided by the power supply 102 to the plasma reduces below the predetermined limit for a certain period of time.

The oscillatory voltage waveform parameters, such as amplitude, frequency, rise time and fall time of the initial voltage oscillations are chosen such that the resulting oscillating electric field 149 ionizes the feed gas 108, thus igniting the plasma in the chamber 104. In one embodiment, the oscillatory voltage waveform parameters of at least a portion of the oscillatory voltage waveform are adjusted to control the electron energy and, therefore, to control the ionization process in order to increase the ionization efficiency of the gas. In one embodiment, the oscillatory voltage waveform parameters of at least a portion of the oscillatory voltage waveform are adjusted to control the electron energy and, therefore, to control the ionization process in order to increase the ionization efficiency of the sputtered material and the feed gas. These parameters can be adjusted so that the electrons gain enough energy in the applied electric field to produce ionization in a high fraction of the collisions with electrically neutral particles.

In embodiments that inject the second process or feed gas 108', there are different types of neutral atoms and/or molecules present in plasmas. For example, the second feed gas 108' can be a reactive gas for reactive material processing, such as reactive ion etching. Each of the different types of neutral atoms and/or molecules typically has a different ionization energy level. In one embodiment, voltage waveforms having oscillatory voltage waveform parameters are applied to produce and sustain a high level of ionization for more than one type of neutral atoms and/or molecules in the plasma discharge.

In some applications, such as magnetron plasma sputtering applications, the energy supplied to the plasma by the power supply 102 is relatively high. The relatively high energy can result in overheating the cathode assembly 116 and the anode 124 as well as overheating the work piece in the chamber 104. In some embodiments, cooling mechanisms are used to cool the cathode assembly 116 and the anode 124. However, the cooling process can cause temperature gradients in the chamber 104. These temperature gradients can cause non-uniformities in the plasma density, which can cause non-uniform plasma process.

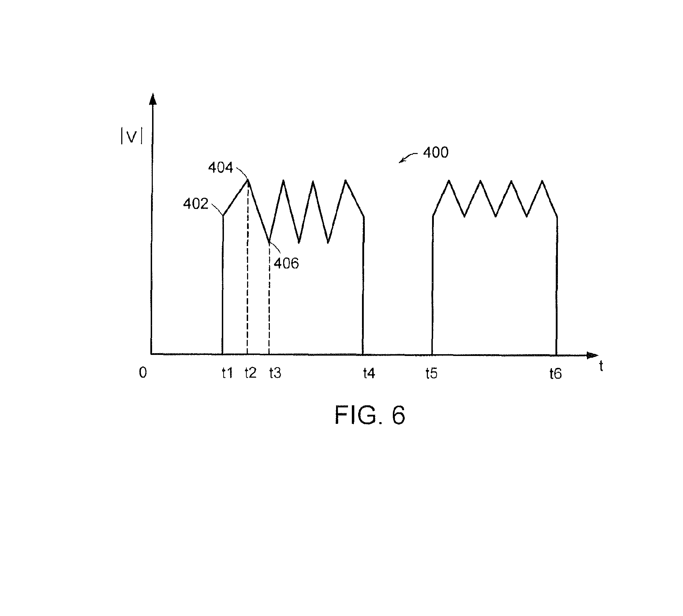

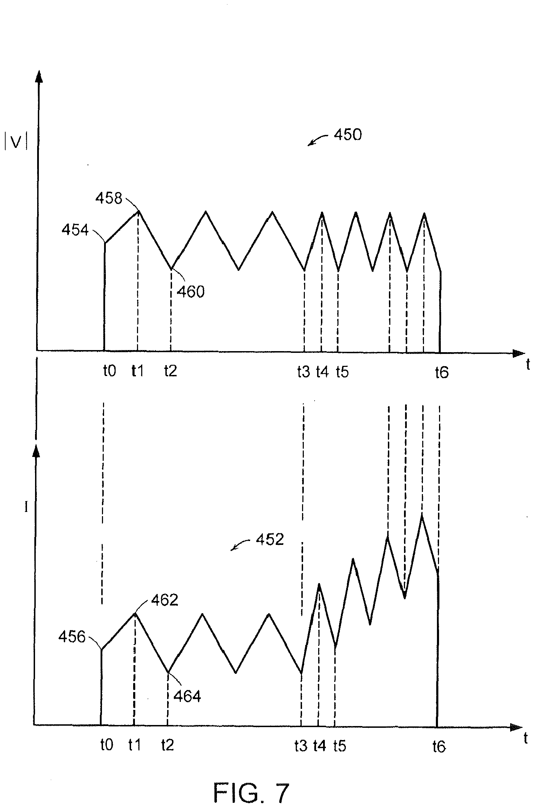

In one embodiment, the temperature gradients are reduced by pulsing the oscillatory voltage waveform as described in connection with FIG. 6. Pulsing the oscillatory voltage waveform can allow the use of lower average power and thus a lower temperature plasma process. However, pulsed waveforms are prone to arcing at plasma ignition and plasma termination, especially when working with high-power pulses. Arcing can result in the release of undesirable particles in the chamber that can contaminate the work piece. Arcing can be reduced or eliminated in embodiments that include pulsing the oscillatory voltage waveform by reducing the frequency of a portion of the oscillatory voltage waveform as described in connection with FIG. 7.

In one embodiment, ignition of the plasma is enhanced by one or more methods described in co-pending U.S. Patent Application No. 10/065,277, entitled High-Power Pulsed Magnetron Sputtering, and U.S. Patent No. 6,853,142 B2, entitled Methods and Apparatus for Generating High-Density Plasma, which are assigned to the present assignee. The entire disclosures of U.S. Patent Application No. 10/065,277 and U.S. Patent No. 6,853,142 B2 are incorporated herein by reference. U.S. Patent No. 6,853,142 B2 describes a method of accelerating the ignition of the plasma by increasing the feed gas pressure for a short period of time and/or flowing feed gas directly through a gap between an anode and a cathode assembly. In addition, U.S. Patent Application No. 10/065,277 describes a method of using pre-ionization electrodes to accelerate the ignition of the plasma.

The plasma is maintained by electrons generated by the electric field 149 and also by secondary electron emission from the target 118. In embodiments including the magnet assembly 130, the magnetic field 132 is generated proximate to the target surface 133. The magnetic field 132 confines the primary and secondary electrons in a region 134 thereby concentrating the plasma in the region 134. The magnetic field 132 also induces the electron Hall current 135 proximate to the target surface 133 that further confines the plasma in the region 1 34.

In one embodiment, the magnet assembly 130 includes an electromagnet in addition to a permanent magnet. A magnet power supply (not shown) is electrically connected to the magnetic assembly 130. The magnet power supply can generate a constant current that generates a constant magnetic filed. Alternatively, the magnet power supply can generate a pulse that produces a pulsed magnetic field that creates an increase in electron Hall current 135 proximate to the target surface 133 that further confines the plasma in the region 134. In one embodiment, the pulsing of the magnetic field is synchronized with the pulsing of the electric field in the plasma discharge in order to increase the density of the plasma. The oscillatory voltage can generate the oscillatory behavior of the electron Hall current 135. This behavior can create a transient non-steady state plasma.

Ions in the magnetron plasma bombard the target surface 133 because the target 118 is negatively biased by oscillatory voltage waveform. For example, the target 118 may be formed of Al, Ti, Ta, Cu, C, Au, Ag, Ni, or W, or can be a compound sputtering target formed of several different materials, such as TiAl, NiV... The impact caused by the ions bombarding the target surface 133 dislodges or sputters material from the target 118. The sputtering rate generally increases as the density of the plasma increases.

The atoms sputtered from the target 118 are present in the plasma discharge. The ionization potential of the sputtered material is typically less than the ionization potential for the sputtered gas atoms or molecules. For example, Argon has a first ionization potential of about 15.75eV, which Ti has a first ionization potential of about 6. 82eV, Al has a first ionization potential of about 5.98eV, Cr has a first ionization potential of about 6.76eV, Carbon has a first ionization potential of about 11.26eV. In one embodiment, the oscillatory voltage waveform parameters of at least a portion of the oscillatory voltage waveform are adjusted to control the electron energy and, therefore, to control the ionization process in order to increase the ionization efficiency of the sputtered atoms. The oscillatory voltage waveform parameters can be adjusted so that the electrons gain enough energy in the applied electric field to produce ionization of the target atoms in a high fraction of the collisions with electrically neutral particles. In this embodiment, the plasma will include a relatively high fraction of ionized metal ions. In one embodiment, the ratio of sputtered metal ions to sputtered metal neutral atoms is in the range of about 5% to 95%. Ionized metal ions are widely used in I-PVD (ionized physical vapor deposition) processes.

In some embodiments, the oscillatory voltage waveform has at least two sets of parameters that produce and sustain a high level of ionization for at least two types of sputtered atoms. For example, the oscillatory voltage waveform can have two sets of parameters that produce and sustain a high level of ionization for ions a multiple element target material, such as TiAl.

In some embodiments, the RF power supply 142 applies a negative RF bias voltage to the substrate 138 that attracts positively ionized sputtered material and gas ions to the substrate 138. The sputtered material forms a film of target material on the substrate 138. The magnitude of the RF bias voltage on the substrate 138 can be chosen to optimize parameters, such as film stress, film morphology, and adhesion of the sputtered film to the substrate 138. In one embodiment, the negative bias on the substrate is in the range of about -1 to -50V. The magnitude of the RF bias voltage on the substrate 138 can also be chosen to minimize damage to the film deposited on the substrate 138. In embodiments including the temperature controller 148, the temperature of the substrate 1 38 is regulated by the temperature controller 148 in order to avoid overheating the substrate 138.

In one embodiment, the power supply 142 is a DC power supply that generates a relatively large negative bias voltage that is in the range of about -500V to -100Kv. The ions from the sputtered target material accelerate to high energies 500eV and 100KeV and can be implanted in the substrate's surface layer prior the deposition process. Implanted ions can significantly improve adhesion between film and substrate.

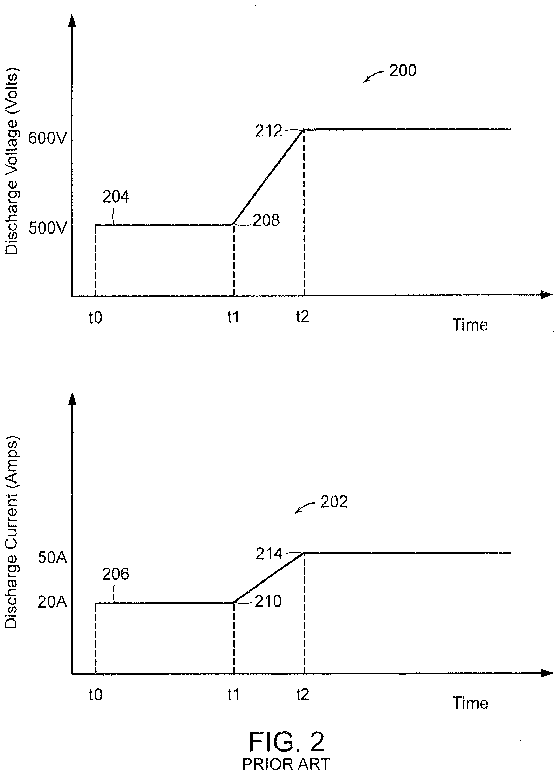

A DC electrical discharge is generally characterized by its discharge voltage and its discharge current waveforms. FIG. 2 illustrates data for discharge voltage 200 and discharge current waveforms 202 as a function of time for a known DC plasma generator. An electrical discharge is ignited at time t0. The electrical discharge establishes an initial discharge voltage 204 of about 500V and an initial discharge current 206 of about 20A. In some embodiments the initial discharge current can be very low. In other embodiments, there is no initial discharge.

At time t1, the discharge voltage 208 monotonically increases. The corresponding discharge current 210 monotonically increases with the increasing discharge voltage. The discharge voltage 212 peaks at about 600V and the corresponding discharge current 114 peaks at about 50A. After time t2, the discharge voltage and the discharge current remain constant. The time between t1 and t2 is on order of 10ms for some apparatus.

Thus, in known plasma discharge systems, a high current electrical discharge can be generated by applying a high voltage. Electrons in plasmas generated by these known plasma discharge systems gain energy from the electric field generated by applied voltage 212 and loose energy in elastic and non elastic collisions with others particles. The particles can be any neutral atom or molecule, ion, or electron that is present in the gas discharge.

The non elastic collisions can result in excitation or ionization processes if the electron energy, is over certain excitation and ionization thresholds of the particles. Electrons can loose energy in elastic collisions (gas heating) and in non elastic collisions with neutral atoms and molecules before ionizing neutral atom. In addition, it is difficult to control the ionization process because of the high rate of collisions.

The methods and apparatus for generating high-current electrical discharges according to the present invention include applying an oscillatory voltage to across the anode and the cathode assembly to generate a plasma from a feed gas. An oscillatory voltage allows the user to obtain a high discharge current with a relatively low discharge voltage. In some embodiments, of the present invention, a high density of metal ions can be generated at relatively low discharge voltages.

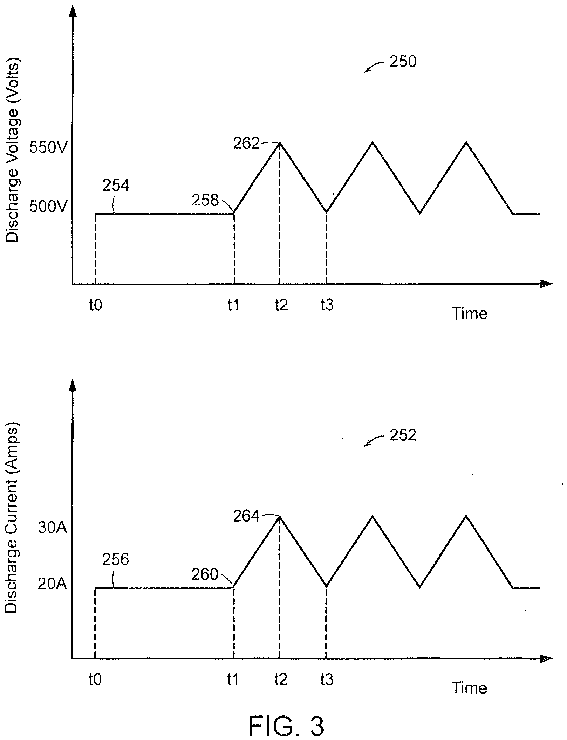

FIG. 3 illustrates data for discharge voltage 250 and discharge current waveforms 252 as a function of time for a plasma generator powered by relatively slow discharge voltage oscillations according to the present invention. The oscillatory discharge voltage can be positive, negative, or have both a positive portion and a negative portion. An electrical discharge is ignited at time t0. The electrical discharge establishes an initial voltage 254 of about 500V and initial discharge current 256 of about 20 A.

In some embodiments, the absolute value of the discharge voltage 254 is in the range of about 10V to 100KV and the discharge current is in the range of about 0.1A to 100,000A. At time t1, the discharge voltage 258 increases from the initial discharge voltage of about 500V. The corresponding discharge current 260 increases with the increasing discharge voltage. In some embodiments, the time interval between t1 and t0 is less than 100 sec. At time t2, the discharge voltage 262 peaks at about 550V and the corresponding discharge current 264 peaks at about 30A. In some embodiments, the absolute value of the difference between the discharge voltage 258 and the discharge voltage 262 is in the range of about 0.1 V to 10,000V.

The increase in discharge voltage from 500V to 550V during the time interval between t2 and t1 provides additional energy to the electrons between the collisions and results in the increase in the discharge current in the time interval between time t1 and time t2. The electron and ion density of the plasma increases. In one embodiment, the increase in the discharge voltage and the time interval from time t1 to time t2 is selected to provide enough energy to the electrons between the collisions to achieve the desired ionization rate of at least one of the feed gas and the sputtering material.

In some embodiments of the invention, the time interval between t2 and t1 is on order of 10ms. In others embodiments, the time interval between t2 and t1 is in the range of about 1 ns-100 ms depending on the particular plasma device and the particular neutral atoms/molecules. In some embodiments, the absolute value of the difference between the voltages at times t2 and t1 is in the range 0.1V and 10,000V.

After time t2, the discharge voltage and the corresponding discharge current decrease. At time t3, the discharge voltage has decreased to approximately the level of the initial discharge voltage 254 (about 500V) and the discharge current has decrease to approximately the initial discharge current 152 (about 20 A).

In some embodiments, the discharge voltage at time t3 decreased to a voltage that is more than the initial voltage at time t1. In some embodiments, the discharge voltage at time t3 decreased to a voltage that is less than the initial voltage at time t1. In other embodiments, the absolute value of the difference between the voltages at times t1 and t2 is in the range of about 0.1 V and 10,000V. The decrease in discharge current occurs because the energy that the electrons gain between collisions decreases during the time interval between t2 and t3. In some embodiments, the time interval between t2 and t3 is in the range of about 1 ns-100ms.

After time t3, the discharge voltage and the discharge current both increase again and the discharge voltage 250 and the discharge current 252 waveform repeat. In the embodiment shown in FIG. 2, the discharge voltage waveform 250 has oscillations that are slow enough so that the discharge current 252 has enough time to decrease to the initial discharge current 256 before increasing again. Thus, the time that the discharge current 252 decreases with the decreasing discharge voltage (i.e. the time interval between time t3 and time t2) is large enough so that the discharge current has time to decrease to its initial discharge current 256. In some embodiments, the difference between time t3 and time t2 is on order of 10 ms.

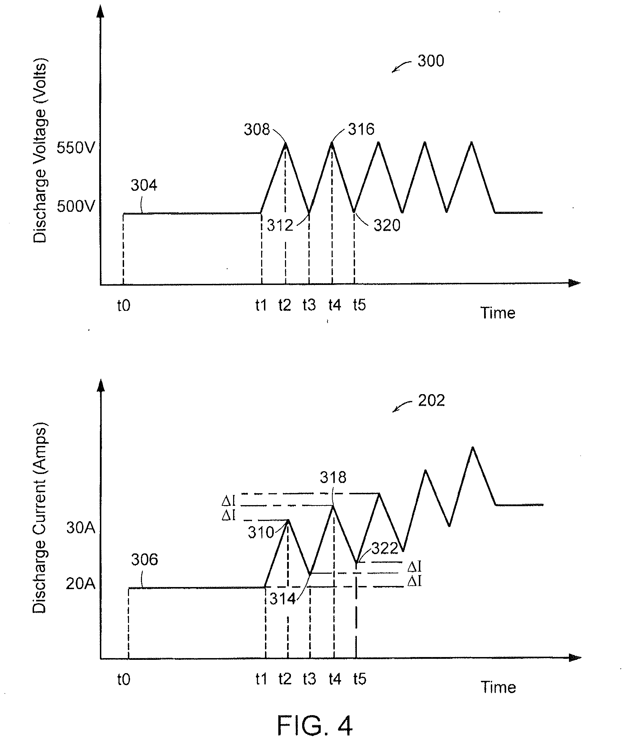

FIG. 4 illustrates data for discharge voltage 300 and discharge current waveforms 302 as a function of time for a plasma generator powered by relatively fast discharge voltage oscillations according to the present invention. The oscillatory discharge voltage can be positive, or negative, or have negative or positive portion. An electrical discharge is ignited at time t0. The electrical discharge establishes an initial voltage 304 of about 500V and initial discharge current 306 of about 20A. In some embodiments, the absolute value of discharge voltage 304 could be in the range of about 10 V to 10OKV. At time t1, the discharge voltage increases from the initial discharge voltage 304. The corresponding discharge current increases with the increasing discharge voltage. At time t2, the discharge voltage 308 peaks at about 550V and the corresponding discharge current 310 peaks at about 30A. During the time between t1 and t2 the electrons gained enough energy to increase the probability of ionizing neutral particles. In some embodiments the time interval between t1 and t2 is in the range 1 ns-100ms. In some embodiments, the time difference between t1 and t0 is less than about 100sec.

The discharge voltage and the corresponding discharge current decrease after time t2. At time t3, the discharge voltage 312 has decreased to the initial discharge voltage 304 of about 500V. In some embodiments, the amplitude of the discharge voltage 312 decreases to an amplitude that is slightly high than the amplitude of the initial discharge voltage. In some embodiments of the invention, the amplitude of the discharge voltage 312 decreases to an amplitude that is lower than the amplitude of the initial discharge voltage. The corresponding discharge current 314 decreases with the decreasing discharge voltage. However, the discharge current does not have sufficient time to decrease enough to reach the initial discharge current 306. Instead, the discharge current decreases to a current that is greater than the initial discharge current 306 by a current different ΔI. For example; in some embodiments, the current difference ΔI is on order of about 3A.

At time t3, the discharge voltage is again increased and the corresponding discharge current increases with the increasing discharge voltage. At time t4, the discharge voltage peaks at discharge voltage 316 and the corresponding discharge current peaks at discharge current 318. However, the peak discharge current 318 is higher than the previous peak discharge current 310 by the current difference ΔI, which is on order of 3A in some embodiments.

The discharge voltage then decreases. At time t5, the discharge voltage 320 has again decreased to the initial discharge voltage 304. However, the corresponding discharge current 322 does not have sufficient time to decrease enough to reach the previous minimum discharge current 314. Instead, the discharge current decreases to a current that is greater than the previous minimum discharge current 314 by the current difference ΔI and greater than the initial discharge current 306 by a current difference of about 2Al. In some embodiments, the current difference ΔI is about 3A and the current difference 2ΔI is about 6A.

The discharge voltage 300 and the discharge current waveforms 302 repeat. In the following cycles, the discharge voltage 300 increases to substantially the same voltage (308, 316). However, the discharge current 302 increases to successively higher peak currents every cycle. In the embodiment shown in FIG. 3, there is a constant discharge voltage waveform frequency and the discharge current increases by approximately the current difference ΔI every cycle. In this way, the discharge current continues to increase with a substantially constant discharge voltage oscillation, amplitude, rise time and fall time.

In one embodiment, a portion of the electrons has an energy that is equal to about 20eV after the voltage 304 increases to the value 308. During the time between t2 and t3, some of these electrons do not loose energy during collisions. During the time interval between t3 and t4, the same electrons gain again about 20eV. Therefore, the total energy of the electrons can be about 40eV. The continued oscillations can heat the electrons to very high energy levels. The electron energy W(eV) can be expressed by the following equation: W (eV) ∼ (ΔV)N, where ΔV is the voltage oscillation amplitude, and N is the amount of the oscillations. The geometry of the plasma system and the electron radiation is the limiting factor that can restrict the growth of the electron energy.

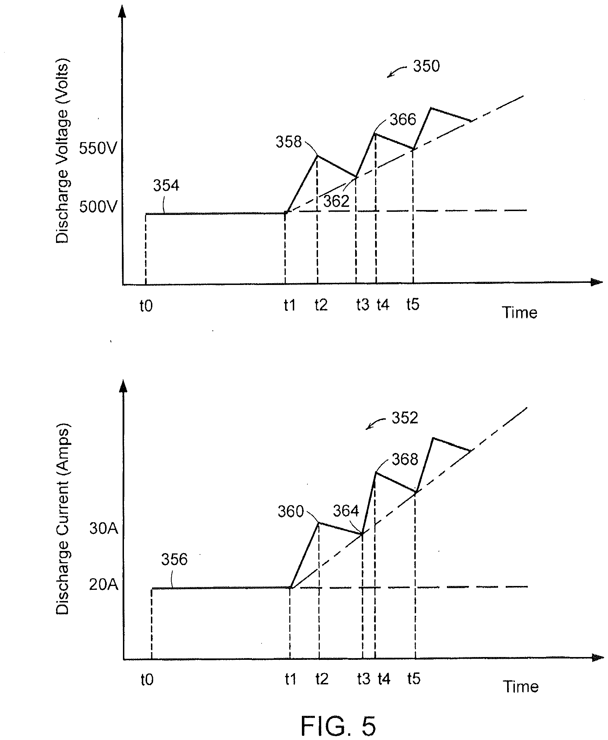

FIG. 5 illustrates data for discharge voltage 350 and discharge current waveforms 352 as a function of time for a plasma generator powered by relatively fast discharge voltage oscillations having a rising voltage according to the present invention. The discharge voltage 350 and the discharge current waveforms 352 are similar to the discharge voltage 300 and discharge current waveform 302 described in connection with FIG. 3. However, the discharge voltage waveform 350 and the discharge current waveform 252 are rising oscillatory voltage waveform. The oscillatory discharge voltage 300 can be positive, negative, or have both a positive portion and a negative portion.

An electrical discharge is ignited at time t0. The electrical discharge established an initial discharge voltage 354 of about 500V and initial discharge current 356 of about 20A. At time t1, the discharge voltage increases from the initial discharge voltage 354. The corresponding discharge current increases with the increasing discharge voltage. At time t2, the discharge voltage 358 peaks at about 550 V and the corresponding discharge current 360 peak at about 30 A.

The discharge voltage and the corresponding discharge current decrease after time t2. At time t3, the discharge voltage 362 has decreased to a local minimum voltage, which is greater than the initial discharge voltage 354. For example, in the embodiment shown in FIG. 4, the minimum discharge voltage is about 510V. The corresponding discharge current decreases with the decreasing discharge voltage to a local minimum discharge current. For example, in the embodiments shown in FIG. 4 the minimum discharge current is about 25 A. The rising slope of the discharge current waveform 352 is higher than the rising slope of the discharge voltage waveform 350 because the discharge current does not have time to fully reach it minimum current as described in connection with FIG. 3.

At time t3, the discharge voltage is again increased and the corresponding discharge current increases with the increasing discharge voltage. At time t4, the discharge voltage 366 and the corresponding discharge current 368 reach peak values. The peak discharge voltage 366 and the peak discharge current 368 peak are both higher than the previous peak discharge voltage 358 and peak discharge current 360 in proportion to their respective rising slopes.

There are many other operating conditions that can be used to increase ionization rates according to the present invention. For example, the discharge voltage and the discharge current waveforms can be saw tooth pulse shape. The discharge voltage and the discharge current waveforms can also be sinusoidal or quasi-sinusoidal waveforms. In addition, the discharge voltage and the discharge current wave forms can be modulated with a relatively high frequency AC modulation signal.

FIG. 6 illustrates data for a discharge voltage waveform as a function of time for a plasma generator powered by a pulsed oscillatory voltage waveform. Pulsing the oscillatory voltage waveform can allow the operator to use lower average powers, which allows the operator to benefit from the advantages of higher power discharges. Pulsing the oscillatory voltage waveform can also lower the temperature of the plasma process. The absolute value of the discharge voltage is presented. The discharge voltage waveform 400 is similar to the discharge voltage 300 described in connection with FIG. 3. However, the discharge voltage waveform 400 does not have a steady state initial value and is pulsed at a repetition rate.

The discharge voltage waveform 400 pulses on to an initial voltage 402. The pulsed discharge voltage waveform 400 then oscillates to a maximum voltage 404 at time t2 and a minimum of voltage 406 at time t3. The oscillations continue and at time t4, the pulse terminates. At time t5, the pulsed discharge voltage waveform 400 again pulses on to an initial voltage 402. The pulsed discharge voltage waveform 400 then oscillates until the pulse is terminated at time t6.

In some embodiments, the pulsed discharge voltage waveform 400 has a repetition rate of pulsed oscillatory voltage waveforms that is in the range of about 1 Hz to 1GHz. In some embodiments, the duration of pulses in the pulsed discharge voltage waveform 400 is in the range of about 10microsecond to 100second. In some embodiments, an average power of pulses in the pulsed discharge voltage waveform 400 is in the range of about 100 W to 500 kW. The peak power of the pulsed voltage waveform is in the range of 100W to 100,000kW.

FIG. 7 illustrates data for discharge current and discharge voltage waveforms as a function of time for a plasma generator powered by an oscillatory voltage waveform having two different frequencies. The oscillatory discharge voltage can be positive, or negative, or have negative or positive portions as described herein. The discharge voltage 450 and the discharge current waveforms 452 are similar to the discharge voltage 300 and discharge current waveform 302 as described in connection with FIG. 3. However, the discharge voltage waveform 450 and the discharge current waveform 452 do not pulse on to initial values and have two different frequencies.

The discharge voltage waveform 450 has an initial voltage 454 at time t0. The corresponding discharge current waveform 452 has an initial current 456. The discharge voltage waveform 450 then oscillates with a first frequency that results in relatively low discharge voltage oscillations. The discharge voltage waveform 450 increases to a local maximum 458 at time t1 and then to a local minimum 460 at time t2. The corresponding discharge current waveform 452 increases to a local maximum 462 at time t1 and then to a local minimum 464 at time t2. The discharge voltage waveform 450 and the discharge current waveform 452 have a first frequency from time t0 to time t3.

At time t3, the frequency of the discharge voltage 450 is increased to a second frequency that results in relatively fast discharge voltage oscillations. As described in connection with FIG. 4, the relatively fast discharge voltage oscillations do not provide sufficient time for discharge current waveform 452 to decrease enough to reach the minimum discharge current 464. Instead, the discharge current waveform 452 decreases to a current that is greater than the minimum discharge current by some current different as described herein. However, the discharge current waveform 452 increases to successively higher peak currents every cycle while the discharge voltage waveforms remains substantially constant as described herein. In other embodiments, the discharge voltage waveform 450 and the discharge current waveform 452 have more than two frequencies.

In some embodiments, the frequency of a relatively slow discharge voltage portion of the discharge voltage waveform 450 is chosen to generate a weakly ionized plasma. The frequency of the relatively fast discharge voltage portion of the discharge voltage waveform 450 is chosen to form a high density plasma. In one embodiment, a discharge voltage waveform 450 in the range 10 to 200 V is applied in order to generate an arc discharge and increase current.

In some embodiments, the change of the amplitude of the voltage oscillation at constant frequency is used to generated weakly ionized plasma in the first portion of the plasma discharge in the time interval between time t0 and t3. Strongly ionized plasma is generated in the second portion of the discharge in the time interval between t3 and t6.

In some embodiments, the change in at least one of the rise time and the fall time of the voltage oscillation at constant frequency is used to generated weakly ionized plasma in the first portion of the plasma discharge in the time interval between time t0 and t3. Strongly ionized plasma is generated in the second portion of the discharge in the time interval between t3 and t6.

A method of generating a weakly ionized plasma and then a strongly ionized plasma is described in U.S. Patent Number 6,853,142 B2, entitled "Methods and Apparatus for Generating High-Density Plasma," which is incorporated herein by reference. U.S. Patent Number 6,853,142 B2 is assigned to the present assignee.

The method of generating a weakly ionized plasma and then a strongly ionized plasma according to the present invention is useful for high deposition rate with a high faction of ionized sputter material. A method of high deposition rate sputtering is described in U.S. Patent Number 6,896,773 B2, entitled "High Deposition Rate Sputtering," which is incorporated herein by reference. U.S. Patent Number 6,896,773 B2 is assigned to the present assignee.

### Equivalents

While the present teachings are described in conjunction with various embodiments and examples, it is not intended that the present teachings be limited to such embodiments. On the contrary, the present teachings encompass various alternatives, modifications and equivalents, as will be appreciated by those of skill in the art, may be made therein without departing from the spirit and scope of the invention as defined by the appended claims.
The following clauses set out features of the invention which may not presently be claimed in this application, but which may form the basis for future amendment or a divisional application.
[Clause 1] A high current density plasma generator comprising: a chamber that contains a feed gas; an anode that is positioned in the chamber; a cathode assembly that is position adjacent to the anode inside the chamber; and a power supply having an output that is electrically connected between the anode and the cathode assembly, the power supply generating at the output an oscillating voltage waveform that generates a plasma from the feed gas, at least one of an amplitude, a frequency, a rise time, and a fall time of the oscillatory voltage being chosen to increase an ionization rate of at least one of feed gas atoms, feed gas molecules, and sputtered material.
[Clause 2] The plasma generator of clause 1 wherein the at least one of the amplitude, the frequency, the rise time, and the fall time of the oscillatory voltage being chosen so that electrons in the plasma gain enough energy to produce ionization of at least one of feed gas atoms, feed gas molecules, and sputtered material in a high fraction of collisions with electrically neutral particles.
[Clause 3] The plasma generator of clause 1 wherein the chosen amplitude is in the range of about 0.1 V to 10KV.
[Clause 4] The plasma generator of clause 1 wherein the chosen pulse frequency is in the range of about 1 KHz to 100GHz.
[Clause 5] The plasma generator of clause 1 wherein at least one of the rise time and the fall time is chosen to be in the range of about 0.1 V/microsecond to 1,000V/microsecond.
[Clause 6] The plasma generator of clause 1 wherein the power supply pulses the oscillatory voltage waveform.
[Clause 7] The plasma generator of clause 6 wherein a repetition rate of the pulsed oscillatory voltage waveform is in the range of about 1 Hz to 1 GHz.
[Clause 8] The plasma generator of clause 6 wherein a duration of pulses in the pulsed oscillatory voltage waveform is in the range of about 10 microsecond to 100 second.
[Clause 9] The plasma generator of clause 6 wherein an average power of the pulsed oscillatory waveform is in the range of about 100W to 500kW.
[Clause 10] The plasma generator of clause 6 wherein a peak power of the pulsed oscillatory waveform is in the range of about 100W to 100,000kW.
[Clause 11] The plasma generator of clause 1 wherein the power supply generates a complex oscillatory voltage waveform that includes at least two sinusoidal waveforms.
[Clause 12] The plasma generator of clause 1 further comprising a magnet that generates a magnetic field proximate to the cathode assembly, the magnetic field confining the plasma proximate to the cathode assembly.
[Clause 13] The plasma generator of clause 12 wherein the magnet comprise a movable magnet.
[Clause 14] The plasma generator of clause 1 wherein the power supply comprises a power mode power supply.
[Clause 15] The plasma generator of clause 1 wherein the power supply comprises a voltage mode power supply.
[Clause 16] The plasma generator of clause 1 wherein the power supply comprises a current mode power supply.
[Clause 17] The plasma generator of clause 1 wherein the feed gas comprises a reactive feed gas.
[Clause 18] The plasma generator of clause 1 wherein the feed gas comprises a mixture of at least two feed gases.
[Clause 19] The plasma generator of clause 1 further comprising a power supply having an output that is electrically connected to a substrate, the power supply biasing the substrate to control energy of ions arriving at the substrate.
[Clause 20] The plasma generator of clause 1 further comprising a temperature controller that is in thermal communication with a substrate, the temperature controller controlling a temperature of the substrate during processing.
[Clause 21] A high current density magnetron sputtering system comprising: a chamber that contains a feed gas; an anode that is positioned in the chamber; a cathode assembly that is position adjacent to the anode inside the chamber, the cathode assembly including a sputtering target having target material; a magnet that is positioned proximate to the cathode assembly, a magnetic field generated by the magnet confining the plasma proximate to the cathode assembly; and a power supply having an output that is electrically connected between the anode and the cathode assembly, the power supply generating at the output an oscillating voltage that generates a plasma from the feed gas, at least one of an amplitude, a frequency, a rise time, and a fall time of the oscillatory voltage being chosen to increase an ionization rate of at least one of feed gas atoms, feed gas molecules and sputtered target material.
[Clause 22] The magnetron sputtering system of clause 21 wherein the at least one of the amplitude, the frequency, the rise time, and the fall time of the oscillatory voltage being chosen so that electrons in the plasma gain enough energy to ionize at least one of feed gas atoms, feed gas molecules, and sputtered target material in a high fraction of the collisions with electrically neutral particles.
[Clause 23] The magnetron sputtering system of clause 21 wherein the magnet comprise a movable magnet.
[Clause 24] The magnetron sputtering system of clause 21 wherein the power supply comprises a power mode power supply.
[Clause 2 5] The magnetron sputtering system of clause 21 wherein the power supply comprises a voltage mode power supply.
[Clause 26] The magnetron sputtering system of clause 21 wherein the power supply comprises a current mode power supply.
[Clause 27] The magnetron sputtering system of clause 21 wherein the feed gas comprises a reactive feed gas.
[Clause 28] The magnetron sputtering system of clause 21 wherein the feed gas comprises a mixture of at least two feed gases.
[Clause 29] The magnetron sputtering system of clause 21 wherein the target material comprises at least two elements.
[Clause 30] The magnetron sputtering system of clause 21 further comprising a power supply having an output that is electrically connected to a substrate, the power supply biasing the substrate to control energy of ions arriving at the substrate.
[Clause 31] The magnetron sputtering system of clause 21 further comprising a temperature controller that is in thermal communication with a substrate, the temperature controller controlling a temperature of the substrate during processing.
[Clause 32] The magnetron sputtering system of clause 21 wherein the power supply comprises a pulsed power supply that generates a pulsed oscillatory voltage waveform.
[Clause 33] The magnetron sputtering system of clause 32 wherein a repetition rate of the pulsed oscillatory voltage waveform is in the range of about 1 Hz to 1 GHz.
[Clause 34] The magnetron sputtering system of clause 32 wherein a duration of pulses with the pulsed oscillatory voltage waveform is in the range of about 10 microsecond to 100 second.
[Clause 35] The magnetron sputtering system of clause 32 wherein an average power of pulses with the pulsed oscillatory voltage waveform is in the range of about 100W to 500kW.
[Clause 36] The magnetron sputtering system of 32 wherein a peak power of pulses with the oscillatory voltage waveform is in the range of about 100W to 100,000kW.
[Clause 37] The magnetron sputtering system of clause 21 wherein the oscillatory voltage forms both a weakly and a strongly ionized plasma.
[Clause 38] The magnetron sputtering system of clause 21 wherein the chosen amplitude is in the range of about 0.1 V to 10 KV.
[Clause 39] The magnetron sputtering system of clause 21 wherein the chosen pulse frequency is in the range of about 1 KHz to 1 GHz.
[Clause 40] The magnetron sputtering system of clause 21 wherein at least one of the rise time and the fall time is chosen to be in the range of about 0.1 V/microsecond to 1,000V/microsecond.
[Clause 41] A method of generating a high current plasma discharge, the method comprising:
   supplying feed gas proximate to an anode and a cathode assembly; generating an oscillatory voltage waveform;
   applying the oscillatory voltage waveform to an anode and a cathode assembly to generate a plasma, at least one of an amplitude, a frequency, a rise time, and a fall time of the oscillatory voltage being chosen to increase an ionization rate of the feed gas.
[Clause 42] The method of clause 41 wherein an average amplitude of the oscillatory voltage is non-zero.
[Clause 43] The method of clause 41 wherein an average amplitude of the oscillatory voltage increases with time.
[Clause 44] The method of clause 41 wherein the oscillatory voltage waveform is pulsed.
[Clause 45] The method of clause 41 wherein the rise times of at least two of the oscillation in the oscillatory voltage waveform are not equal.

## Claims

1. A high current electrical discharge generator comprising:
a) a chamber that contains a feed gas;
b) an anode that is positioned in the chamber;
c) a cathode assembly that is positioned adjacent to the anode inside the chamber; and
d) a power supply having an output that is electrically connected between the anode and the cathode assembly, the power supply being arranged to generate at the output pulse voltage waveforms wherein the pulse voltage waveforms comprise voltage oscillations that produce oscillating electrical discharge currents during at least a portion of the pulse voltage waveforms, at least one of amplitude, rise time, and fall time of the voltage oscillations being chosen to increase an ionization rate of at least one of feed gas atoms, feed gas molecules or sputtered material, a frequency of the voltage oscillation being chosen to reduce arcing during the oscillating electrical discharge.

2. The high current electrical discharge generator of claim 1, wherein the discharge voltage of at least one the voltage oscillations decreases from a maximum value to a minimum value during the time interval between 10 ns and 100 ms,
and/or wherein the discharge voltage of at least one of the voltage oscillations increases from a minimum value to maximum value during the time interval between 10 ns and 100 ms.

3. The high current electrical discharge generator of claim 1 or 2, wherein a time interval between at least two voltage oscillations is in a range of 20 ns and 200 ms.

4. The high current electrical discharge generator of claim 1, 2 or 3, wherein an absolute value of the discharge voltage of the pulse voltage waveforms is in a range of 0.1 V and 10 kV.

5. The high current electrical discharge generator of any preceding claim, wherein the voltage oscillation comprises one of sinusoidal, quasi-sinusoidal or triangular shaped waveforms.

6. The high current electrical discharge generator of any preceding claim, wherein at least a portion of a voltage amplitude between voltage oscillations is negative,
and/or wherein at least a portion of a voltage amplitude between voltage oscillations is positive,
and/or wherein at least a portion of a voltage amplitude between voltage oscillations is equal zero.

7. The high current electrical discharge generator of any preceding claim, further comprising a power supply having an output that is electrically connected to a substrate support positioned in the chamber, the power supply biasing the substrate to control energy of ions arriving at the substrate.

8. The high current electrical discharge generator of any preceding claim, wherein the cathode material comprises at least one of Al, Ti, Ta, Cr, Cu, C, Au, Ag, Ni, and W,
and/or wherein the feed gas comprises at least one noble gas and at least one reactive gas.

9. The high current electrical discharge generator of any preceding claim, wherein the cathode assembly comprises a magnet assembly that generates a magnetic field in the range of 20-2000 G;
preferably wherein the magnet assembly comprises rotating magnets.

10. A method for generating a high current electrical discharge comprising:-providing:
a) a chamber that contains a feed gas;
b) an anode that is positioned in the chamber;
c) a cathode assembly that is positioned adjacent to the anode inside the chamber; and
d) a power supply having an output that is electrically connected between the anode and the cathode assembly; and
generating at the output pulse voltage waveforms comprising voltage oscillations that produce oscillating electrical discharge currents during at least a portion of the pulse voltage waveforms;
wherein at least one of amplitude, rise time, and fall time of the voltage oscillations is chosen to increase an ionization rate of at least one of feed gas atoms, feed gas molecules or sputtered material, and a frequency of the voltage oscillation is chosen to reduce arcing during the oscillating electrical discharge.

11. The method of claim 10, wherein the discharge voltage of at least one the voltage oscillations decreases from a maximum value to a minimum value during the time interval between 10 ns and 100 ms,
and/or wherein the discharge voltage of at least one of the voltage oscillations increases from a minimum value to maximum value during the time interval between 10 ns and 100 ms,
and/or wherein a time interval between at least two voltage oscillations is in a range of 20 ns and 200 ms,
and/or wherein an absolute value of the discharge voltage of the pulse voltage waveforms is in a range of 0.1 V and 10 kV.

12. The method of claim 10 or 11, wherein the voltage oscillation comprises one of sinusoidal, quasi-sinusoidal or triangular shaped waveforms,
and/or wherein at least a portion of a voltage amplitude between voltage oscillations is negative,
and/or wherein at least a portion of a voltage amplitude between voltage oscillations is positive,
and/or wherein at least a portion of a voltage amplitude between voltage oscillations is equal zero.

13. The method of claim 10, 11 or 12, further comprising electrically connecting and output of a power supply to a substrate support positioned in the chamber, and biasing the substrate with the power supply to control energy of ions arriving at the substrate.

14. The method of claim 10, 11, 12 or 13, wherein the cathode material comprises at least one of Al, Ti, Ta, Cr, Cu, C, Au, Ag, Ni, and W,
and/or wherein the feed gas comprises at least one noble gas and at least one reactive gas.

15. The method of claim 10, 11, 12, 13 or 14, wherein the cathode assembly comprises a magnet assembly that generates a magnetic field in the range of 20-2000 G;
preferably wherein the magnet assembly comprises rotating magnets.
